(19) **Europäisches Patentamt / European Patent Office / Office européen des brevets**

(11) **EP 4 616 740 A1**

(12) **EUROPEAN PATENT APPLICATION**
published in accordance with Art. 153(4) EPC

(43) Date of publication:
**17.09.2025 Bulletin 2025/38**

(21) Application number: **22965223.5**

(22) Date of filing: **11.11.2022**

(51) International Patent Classification (IPC):
**A24F 40/51** (2020.01)   **G01R 27/26** (2006.01)
**G01V 3/08** (2006.01)

(52) Cooperative Patent Classification (CPC):
**A24F 40/51; G01R 27/26; G01V 3/08**

(86) International application number:
**PCT/JP2022/042129**

(87) International publication number:
**WO 2024/100900 (16.05.2024 Gazette 2024/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Japan Tobacco Inc.**
**Tokyo 105-6927 (JP)**

(72) Inventors:
• **INOUE, Jumpei**
  **Tokyo 130-8603 (JP)**
• **SAKAI, Ryuji**
  **Tokyo 130-8603 (JP)**

(74) Representative: **Hoffmann Eitle
Patent- und Rechtsanwälte PartmbB
Arabellastraße 30
81925 München (DE)**

(54) **NON-COMBUSTION-TYPE FLAVOR INHALER**

(57)   The non-combustion-type flavor inhaler of the present disclosure comprises an accommodating portion that accommodates a flavor stick having a flavor rod portion and a mouthpiece portion, so as to be capable of being inserted and removed, a control unit that controls electric power supplied to a heating portion for heating the flavor stick, to thereby heat the flavor stick by means of the heating portion, and a capacitance sensor that detects a capacitance that varies in accordance with the state of the flavor stick accommodated in the accommodating portion, wherein: the capacitance sensor comprises a first electrode and a second electrode; and the first electrode and the second electrode are disposed along a bottom surface of the accommodating portion with which a tip end of the flavor stick comes into contact when the flavor stick is inserted to a defined position relative to the accommodating portion. This allows the capacitance sensor to be positioned appropriately, thereby improving the performance of the non-combustion-type flavor inhaler.

[Fig 1]

EP 4 616 740 A1

## Description

### TECHNICAL FIELD

The present invention relates to a non-combustion-type flavor inhaler.

### BACKGROUND ART

Non-combustion-type flavor inhalation systems have been proposed as an alternative to conventional combustion-type cigarettes in which tobacco leaves are burnt for smoking. For example, there are known heat-not-burn type tobacco products comprising an electrically heated device including a heater assembly, a battery unit serving as an electric power source for the heater assembly, and a control unit for controlling a heating element of the heater assembly, etc., and a tobacco stick that is used together with the electrically heated device.

Further, in a non-combustion-type flavor inhaler in which a user inserts a tobacco stick into the inhaler and the tobacco stick is heated, there is a known mechanism that detects the insertion of the tobacco stick by means of a change in capacitance (PTL 1). Furthermore, there is a known mechanism that detects insertion of a tobacco stick and the type of tobacco stick by measuring a capacitance associated with a marker provided on the stick (PTL 2).

### CITATION LIST

### PATENT LITERATURE

PTL 1 JP 2017-510270 A
PTL 2 WO 2019/185748 A1

### SUMMARY OF INVENTION

### TECHNICAL PROBLEM

In a non-combustion-type flavor inhaler, when a capacitance sensor is used to detect the insertion state of a flavor stick (hereinafter also referred to as a tobacco stick), if an attempt is made to dispose the capacitance sensor along a side surface of an accommodating portion, a problem arises in that the capacitance sensor interferes with a heating portion that heats the flavor stick from the periphery of the accommodating portion, and therefore the capacitance sensor has to be disposed so as to avoid the heating portion, making it difficult to dispose the capacitance sensor appropriately. If the capacitance sensor is not disposed appropriately, there is a problem in that the state of the flavor stick cannot be accurately detected, making it difficult to control the non-combustion-type flavor inhaler appropriately to achieve sufficient performance.

The present invention has been made in consideration of the circumstances described hereinabove, and the objective thereof is to provide a technology that enables the performance of a non-combustion-type flavor inhaler to be improved by appropriately disposing a capacitance sensor.

### SOLUTION TO PROBLEM

(Aspect 1)

In order to achieve the above objective, the technology according to the present disclosure relates to a non-combustion-type flavor inhaler comprising

an accommodating portion that accommodates a flavor stick having a flavor rod portion and a mouthpiece portion, so as to be capable of being inserted and removed,
a control unit that controls electric power supplied to a heating portion for heating the flavor stick, to thereby heat the flavor stick by means of the heating portion, and
a capacitance sensor that detects a capacitance that varies in accordance with the state of the flavor stick accommodated in the accommodating portion, wherein:

the capacitance sensor comprises a first electrode and a second electrode; and
the first electrode and the second electrode are disposed along a bottom surface of the accommodating portion with which a tip end of the flavor stick comes into contact when the flavor stick is inserted to a defined position relative to the accommodating portion.

(Aspect 2)

In aspect 1, when the insertion of the flavor stick has been detected by the capacitance sensor, the control unit may perform at least one of turning on the power source, starting heating by means of the heating portion, and notifying the user that the insertion of the flavor stick is complete.

(Aspect 3)

In aspect 1 or 2, the control unit may determine that insertion of the flavor stick is complete when the value of the capacitance detected by the capacitance sensor reaches a prescribed threshold.

(Aspect 4)

In aspect 3, the control unit may detect the capacitance by means of the capacitance sensor when the power source is turned on and no flavor stick has been inserted into the accommodating portion, and correct the value of the capacitance detected by the capacitance sensor on the basis of the detection result.

(Aspect 5)

The control unit may detect the capacitance by means of the capacitance sensor at the time the power source is turned off, if no flavor stick is inserted into the accommodating portion, and correct the value of the capacitance detected by the capacitance sensor when the power source is next turned on, on the basis of the detection result.

(Aspect 6)

In any aspects 1 to 3, the capacitance sensor may be disposed such that the minimum gap between the first electrode and the second electrode, on the same plane along a bottom surface of the accommodating portion, is 7 mm or less.

(Aspect 7)

In any of aspects 1 to 4, the capacitance sensor may be disposed so as to overlap, in the direction in which the flavor stick is inserted and removed, a range of 40% or more and less than 100% of a tip end surface of the flavor stick that has been inserted to the defined position.

It should be noted that the means for solving the problems in the present invention can be adopted in combination as far as possible.

ADVANTAGEOUS EFFECTS OF INVENTION

The present invention makes it possible to provide a technology that enables the performance of a non-combustion-type flavor inhaler to be improved by appropriately disposing a capacitance sensor.

BRIEF DESCRIPTION OF DRAWINGS

Fig. 1 is a schematic configuration diagram of a non-combustion-type flavor inhalation system according to an embodiment.
Fig. 2 is an oblique view of a tobacco stick according to the embodiment.
Fig. 3 is a drawing used to describe the internal structure of the tobacco stick according to the embodiment.
Fig. 4A is a drawing illustrating schematically the internal structure of the non-combustion-type flavor inhaler according to the embodiment.
Fig. 4B is a drawing illustrating schematically the internal structure of a non-combustion-type flavor inhaler provided with a microwave heating type heating portion (induction coil).
Fig. 4C is a drawing illustrating schematically the internal structure of a non-combustion-type flavor inhaler provided with an internal heating type heater.
Fig. 5 is a drawing illustrating an example in which flat plate-shaped electrodes are disposed along a rear wall of the accommodating portion.
Fig. 6 is a drawing illustrating the positional relationship between the first electrode and the second electrode, and the tip end surface of the tobacco stick.
Fig. 7 is a drawing illustrating the configuration of a control unit.
Fig. 8 is a drawing illustrating a control method executed by the control unit.

DESCRIPTION OF EMBODIMENTS

Embodiments of a flavor stick and a non-combustion-type flavor inhalation system according to the present invention will now be described on the basis of the drawings. It should be noted that the dimensions, materials, shapes, and relative positions, etc., of the components described in the present embodiment are examples. For example, in the present embodiment, a flavor stick (hereinafter also referred to as a 'tobacco stick') containing a tobacco filler as a flavor source is described as an example of a flavor stick, but the flavor stick does not need to contain a tobacco filler, and main contain other flavor components.

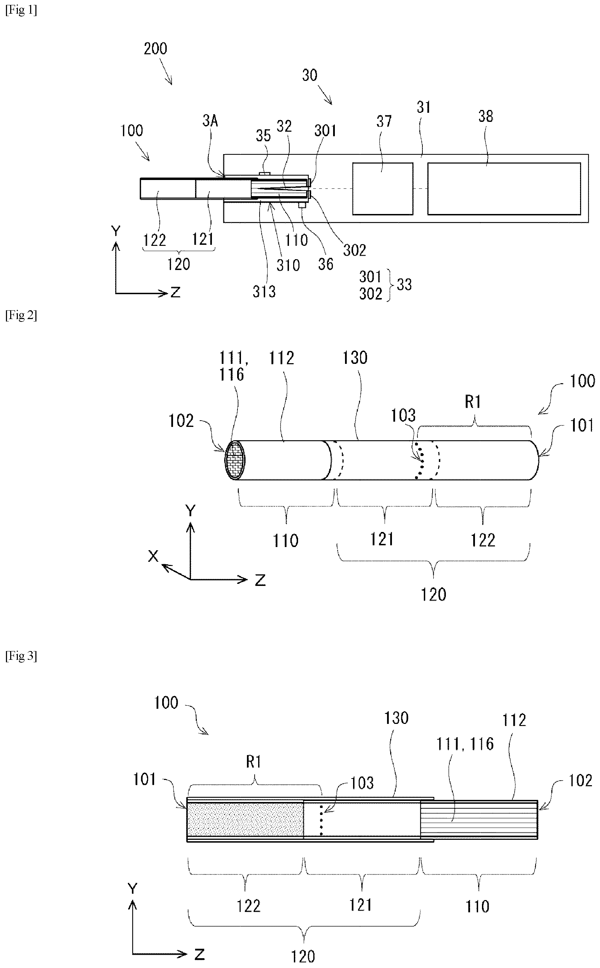

Fig. 1 is a schematic configuration diagram of a non-combustion-type flavor inhalation system 200 according to the embodiment. Fig. 2 is an oblique view of a tobacco stick 100 according to the embodiment, and Fig. 3 is a drawing used to describe the internal structure of the tobacco stick 100 according to the embodiment. In Fig. 1 to Fig. 3, the left-right direction of the tobacco stick 100 or the non-combustion-type flavor inhaler 30 into which the tobacco stick 100 is inserted is represented as the X direction, the up-down direction is represented as the Y direction, and the depth direction is represented as the Z direction. It should be noted that the same applies for the subsequent drawings. These directions are merely illustrative, for convenience of explanation, and do not limit the elements of the non-combustion-type flavor inhalation system 200. For example, the elements of the non-combustion-type flavor inhalation system 200 are not limited to being arranged in the directions illustrated in the drawings.

The non-combustion-type flavor inhalation system 200 comprises a tobacco stick 100 and a non-combustion-type flavor inhaler 30 which heats a tobacco rod portion (flavor rod portion) 110 of the tobacco stick 100. The tobacco stick 100 is accommodated in an accommodating cavity 313 of an accommodating portion 310 in such a way as to be capable of being inserted into and removed from the accommodating cavity 313 through an insertion opening 3A of the non-combustion-type flavor inhaler 30.

When a user uses the non-combustion-type flavor inhaler 30, the tobacco stick 100 is inserted into the accommodating cavity 313, and in this state a heater 32 provided within the accommodating portion 310 is caused to generate heat to heat the tobacco filler within the tobacco stick 100, thereby generating an aerosol containing a tobacco component to be inhaled by the user. At this time, the tobacco stick 100 is inserted to a defined position relative to the accommodating portion 310 so as to be capable of being heated by the heater 32. In the present embodiment, the tobacco stick 100 is inserted into the accommodating portion 310 in the Z direction, and the defined position is the position at which the tip end of the tobacco stick 100 abuts a bottom surface 319 of the accommodating portion 310.

[Tobacco stick]

The tobacco stick 100 according to the present embodiment takes the form of a substantially cylindrical rod. In the example illustrated in Fig. 2 and Fig. 3, the tobacco stick 100 comprises the tobacco rod portion 110, a mouthpiece portion 120 and tipping paper 130 that integrally links the components together. The mouthpiece portion 120 is linked coaxially to the tobacco rod portion 110 by being wrapped together with the tobacco rod portion 110 by the tipping paper 130.

Reference sign 101 denotes the mouthpiece end of the tobacco stick 100 (mouthpiece portion 120). Reference sign 102 denotes the tip end of the tobacco stick 100 on the opposite to the mouthpiece end 101. The tobacco rod portion 110 is disposed on the tip end 102 side of the tobacco stick 100. In the example illustrated in Fig. 2 and Fig. 3, the tobacco stick 100 has a substantially constant diameter over the entire length in the longitudinal direction (also referred to hereinafter as the axial direction or the Z direction) from the mouthpiece end 101 to the tip end 102.

[Tipping paper]

There is no particular restriction on the material of the tipping paper 130, and it is possible to employ paper made of common vegetable fibers (pulp), a sheet made from polymer-based (polypropylene, polyethylene, nylon, etc.) chemical fibers, a polymer-based sheet, metal foil, or a composite material combining the above. For example, the tipping paper 130 may be fabricated from a composite material in which a polymer-based sheet is laminated onto a paper substrate. It should be noted that the tipping paper 130 referred to here refers to a sheet-like material that connects a plurality of segments of the tobacco stick 100, such as, for example, linking the tobacco rod portion 110 and the mouthpiece portion 120.

There is no particular restriction on the method for manufacturing the tipping paper 130, and general methods can be applied, and for example in the case of an embodiment in which pulp is the main component, a method that uses pulp can be cited, in which the texture is adjusted and homogenized in a papermaking process employing a Fourdrinier paper making machine, a cylinder mould paper making machine, or a round-short combined paper making machine, etc. It should be noted that, if necessary, a wet strength agent can be added to impart water resistance to wrapping paper, or a sizing agent can be added to adjust a printing condition of the wrapping paper.

<Tobacco rod portion>

There is no particular restriction on the configuration of the tobacco rod portion 110, and it may take a general form. For example, a tobacco filler 111 wrapped with wrapping paper 112 can be used.

[Tobacco filler]

In the present embodiment, the tobacco filler 111 is configured to contain tobacco shreds. There is no particular restriction on the material of the tobacco shreds contained in the tobacco filler 111, and well-known materials such as lamina and midrib can be used. Furthermore, ground tobacco may be formed by grinding dried tobacco leaves to an average particle size of 20 $\mu$m or more and 200 $\mu$m or less, then homogenized and processed into a sheet (also referred to below simply as a "homogenized sheet") which is shredded. In addition, the tobacco rod may be filled with a material obtained by shredding, in the longitudinal direction of the tobacco rod and substantially horizontally, a homogenized sheet having a length similar to that of the tobacco rod in the longitudinal direction, forming what is known as a "strand-type" filling material. Furthermore, the width of the tobacco shreds is preferably 0.5 mm or more and 2.0 mm or less in order to fill the tobacco rod portion 110. Also, although there is no particular restriction on the content of dried tobacco leaves contained in the tobacco rod portion 110, 200 mg/rod portion or more and 800 mg/rod portion or less can be cited, and 250 mg/rod portion or more and 600 mg/rod portion or less is preferred. This range is particularly suitable if the tobacco rod portion 110 has a circumference of 22 mm and a length of 20 mm.

Various types of tobacco used can be used for the tobacco leaves used in the production of the tobacco shreds and the homogenized sheet. Examples that may be cited include yellow, Burley, orient, or native type, and other Nicotiana tabacum and Nicotiana rustica varieties, and mixtures thereof. A suitable blend of the abovementioned varieties may be used in a mixture to achieve the intended taste. Details of the tobacco varieties are further described in "Dictionary of tobacco, the Tobacco Research Center, 2009.3. There are multiple conventional methods for producing the homogenized sheet, that is, methods for grinding tobacco leaves and processing them into a homogenized sheet. According to a first method, a paper sheet is produced using a papermaking process. According to a second method, a suitable solvent such as water is mixed with ground tobacco leaves and the mixture is homogenized, after which the homogenized material is thinly cast on a metal plate or a metal plate belt and dried, to produce a cast sheet. According to a third method, a suitable solvent such as water is mixed with ground tobacco leaves and the mixture is homogenized, and the homogenized material is then extruded into the form of a sheet and shaped to produce a calendered sheet. Details of types of homogenized sheets are disclosed in "Dictionary of Tobacco, Tobacco Academic Studies Center, 2009.3.31".

The moisture content of the tobacco filler 111 can be cited as 10 wt% or more and 15 wt% or less, and preferably 11 wt% or more and 13 wt% or less, with respect to the total weight of the tobacco filler 111. A moisture content such as this suppresses the formation of wrapping stains and improves rolling suitability when the tobacco rod portion 110 is produced. There is no particular restriction on the size or method of preparation of the tobacco shreds contained in the tobacco filler 111. For example, a material obtained by shredding dried tobacco leaves to a width of 0.5 mm or more and 2.0 mm or less may be used. Furthermore, when ground material is used in the homogenized sheet, a sheet may be formed by grinding dried tobacco leaves to an average particle size of approximately 20 $\mu$m to 200 $\mu$m and then homogenizing the ground tobacco, and the homogenized sheet may be shredded to a width of 0.5 mm or more and 2.0 mm or less for use.

The tobacco filler 111 may comprise an aerosol base material for generating aerosol smoke. There is no particular restriction on the type of aerosol base material, and extracts from various types of natural products and/or components thereof may be selected in accordance with the application. Aerosol base materials which may be cited include glycerol, propylene glycol, triacetin, 1,3-butanediol, and mixtures thereof. There is no particular restriction on the amount of the aerosol base material contained in the tobacco filling material, and the amount is normally 5 wt% or greater and preferably 10 wt% or greater, and normally 50 wt% or less, and preferably 15 wt% or greater and 25 wt% or less, with respect to the total amount of tobacco filler, from the point of view of generating sufficient aerosol and imparting a good flavor.

The tobacco filler 111 may contain a flavoring such as menthol, for example. There is no particular restriction on the amount of flavoring contained in the tobacco filler 111, and, from the point of view of imparting a good flavor, the content is normally 10,000 ppm or greater, preferably 20,000 ppm or greater, and more preferably 25,000 ppm or greater, and is normally 70,000 ppm or less, preferably 50,000 ppm or less, more preferably 40,000 ppm or less, and even more preferably 33,000 ppm or less.

[Wrapping paper]

The wrapping paper 112 is a sheet material for wrapping the tobacco filler 111, there being no particular restriction on the composition thereof, and a common wrapping paper can be used. For example, cellulose fiber paper can be used as the base paper used for the wrapping paper 112, and more specifically hemp or wood, or mixtures thereof, can be cited.

In addition to the above, the wrapping paper 112 may comprise fillers such as calcium carbonate, titanium dioxide, kaolin, etc. Various auxiliaries other than the base paper and the fillers may also be added to the wrapping paper 112, for example water-resistance improving agents such as a wet strength agent (WS agent) and a sizing agent can be added to improve water resistance. The wrapping paper 112 may also be coated as appropriate.

The axial length of the tobacco rod portion 110 may be varied as appropriate in accordance with the size of the product, but, for example, is 5 mm or more, preferably 10 mm or more, more preferably 12 mm or more, and even more preferably 18 mm or more, and is normally 70 mm or less, preferably 50 mm or less, more preferably 30 mm or less, and even more preferably 25 mm or less.

<Mouthpiece portion>

There is no particular restriction on the configuration of the tobacco stick 100, and it may take a general form. In the aspect illustrated in Fig. 1, the mouthpiece portion 120 comprises two segments (sections), namely a cooling segment 121 and a filter segment 122. The cooling segment 121 is disposed so as to be sandwiched between and in contact with the tobacco rod portion 110 and the filter segment 122. In another aspect, gaps may be formed between the tobacco rod portion 110 and the cooling segment 121 and between the tobacco rod portion 110 and the filter segment 122. Furthermore, the mouthpiece portion 120 may be formed from a single segment.

[Cooling segment]

There is no particular restriction on the configuration of the cooling segment 121, provided that it has the function of cooling tobacco mainstream smoke, and cardboard processed into a cylindrical shape can be cited, for example. In this case, the inside of the cylinder is a cavity, and vapor containing an aerosol generating substrate and a tobacco flavor component comes into contact with air in the cavity and is cooled.

One aspect of the cooling segment 121 may be a paper tube obtained by processing a single sheet of paper or paper made by bonding a plurality of sheets of paper together, to form a cylindrical shape. In addition, in order to increase the cooling effect by bringing room temperature outside air into contact with high temperature vapor, there are preferably holes around the paper tube for introducing external air. Ventilation holes 103, which are openings for taking in air from the outside, are provided in the cooling segment 121. There is no particular restriction on the number of ventilation holes 103 in the cooling segment 121.

[Filter segment]

There is no particular restriction on the configuration of the filter segment 122 provided that it has the function of a general filter, and cellulose acetate tow processed into a cylindrical shape can be cited, for example. There is no particular limitation on the single-yarn fineness or the total fineness of the cellulose acetate tow, but in the case of a filter segment having a circumference of 22 mm, the single-yarn fineness is preferably 5 to 20 g/9000 m, and the total fineness is preferably 12,000 to 30,000 g/9000 m. The cross-sectional shape of the fibers of cellulose acetate tow may be either a Y cross section or an R cross section. When the filter segment 122 is formed by filling with cellulose acetate tow, triacetin may be added in an amount of 5 to 10 wt% with respect to the weight of the cellulose acetate tow in order to improve the filter hardness. In the example illustrated in Fig. 2, the filter segment 122 is configured from a single segment, but the filter segment 122 may be configured from a plurality of segments.

Examples of general functions of the filter in the filter segment 122 which may be cited include adjusting the amount of air which is mixed when the aerosol, etc. is inhaled, lightening the flavor, and lightening nicotine and tar, etc., but not all of these functions need to be provided. Furthermore, in an electrically heated tobacco product, which generates fewer components and tends to have a lower filling ratio of the tobacco filler than a cigarette product, an important function of the filter also lies in preventing the tobacco filler from falling out, while controlling a filtration function.

The rod-shaped tobacco stick 100 preferably has a columnar shape satisfying a shape in which the aspect ratio defined below is equal to or greater than 1.

$$\text{Aspect ratio} = h/w$$

w is the width of the tip end 102 of the tobacco stick 100, and h is the length in the axial direction, and preferably $h \geq w$. There is no particular restriction on the cross-sectional shape of the tobacco stick 100, and it can be polygonal, rounded-corner polygonal, circular, or elliptical, etc. The width w of the tobacco stick 100 is the diameter when the cross-sectional shape of the tobacco stick 100 is circular, the major diameter when the cross-sectional shape of the tobacco stick 100 is elliptical, or the diameter of a circumscribed circle or the major diameter of a circumscribed ellipse when the cross-sectional shape of the tobacco stick 100 is polygonal or rounded-corner polygonal. There is no particular restriction on the axial length h of the tobacco stick 100, and it is normally 40 mm or greater, preferably 45 mm or greater, and more preferably 50 mm or greater, for example. Furthermore, the axial length h is normally 100 mm or less, preferably 90 mm or less, and more preferably 80 mm or less. There is no particular restriction on the width w of the tobacco stick 100, and it is normally 5 mm or greater, and preferably 5.5 mm or greater, for example. Furthermore, the width w is normally 10 mm or less, preferably 9 mm or less, and more preferably 8 mm or less. There is no particular restriction on the ratio (cooling segment : filter segment) between the lengths of the cooling segment 121 and the filter segment 122, in the length of the tobacco stick 100, but from the viewpoint of the amount of flavoring delivered and the appropriate aerosol temperature, it is normally 0.60 to 1.40 : 0.60 to 1.40, preferably 0.80 to 1.20 : 0.80 to 1.20, more preferably 0.85 to 1.15 : 0.85 to 1.15, even more preferably 0.90 to 1.10 : 0.90 to 1.10, and particularly preferably 0.95 to 1.05 : 0.95 to 1.05. By setting the ratio between the lengths of the cooling segment 121 and the filter segment 122 within the above range, a balance is achieved between the cooling effect, the effect of suppressing losses due to adhesion of the generated vapor and aerosol to the inner wall of the cooling segment 121, and the function of the filter for adjusting the volume of air and the flavor, thereby making it possible to achieve a good flavor and flavor intensity.

<Non-combustion-type flavor inhaler>

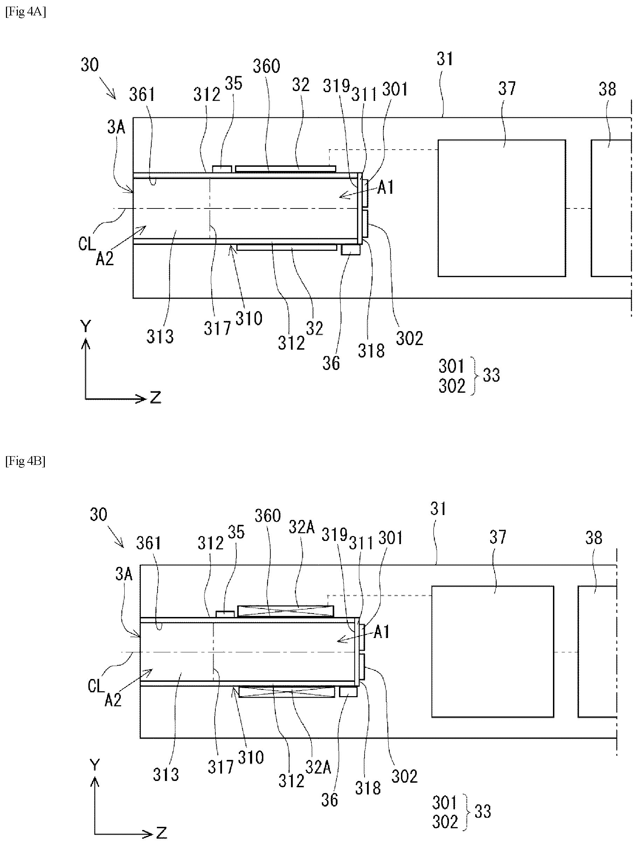

Fig. 4A is a diagram schematically illustrating the internal structure of the non-combustion-type flavor inhaler 30 according to a first embodiment. The non-combustion-type flavor inhaler 30 has a housing 31, which is a casing for accommodating various components. The housing 31 accommodates a heater 32, a capacitance sensor 33, a temperature sensor 35, an inhalation sensor 36, a control unit 37, and a power source 38, etc.

[Accommodating portion]

The housing 31 has an accommodating portion 310 which accommodates the tobacco stick 100 from a front end toward a rear end side so as to be capable of being inserted and removed. The accommodating portion 310 comprises a cylindrical peripheral wall 312 that extends in the insertion/removal direction of the tobacco stick 100 and that defines the outer periphery of a space into which the tobacco stick 100 is inserted, and a disc-shaped rear wall 311 that closes the rear end of the peripheral wall 312 so as to define the rear end of the space. The peripheral wall 312 or the rear wall 311 of the accommodating portion 310 may be formed integrally with the housing 31, or may be formed separately from the housing 31 and assembled to the housing 31. In the present embodiment, the inner wall surface of the rear wall 311, i.e. the surface thereof on the side of the space into which the tobacco stick 100 is inserted, is the bottom surface 319 of the accommodating portion 310.

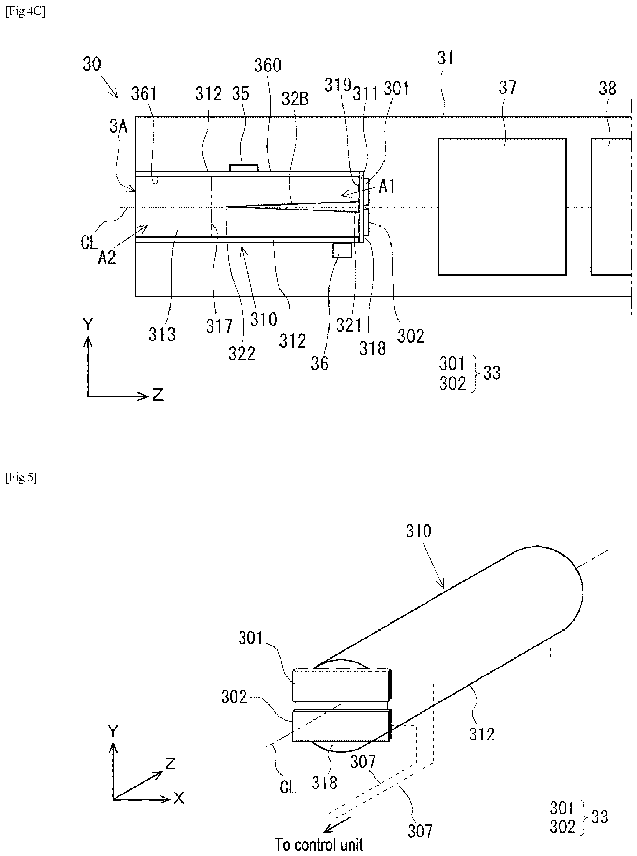

The open end of the peripheral wall 312 of the accommodating portion 310 is open towards the outside of the housing 31 and serves as an insertion opening 3A for inserting the tobacco stick 100. Furthermore, the internal space of the peripheral wall 312 is a cylindrical accommodating cavity 313 into and from which the tip end part of the tobacco stick 100 can be inserted and removed via the insertion opening 3A. In Fig. 4, reference sign CL indicates the central axis of the accommodating cavity 313 in the insertion/removal direction of the tobacco stick 100. Hereinafter, the direction along the central axis CL is also referred to as the axial direction. It should be noted that the outer diameter of the accommodating cavity 313, i.e. the inner diameter of the peripheral wall 312, may be equal to the outer diameter of the tobacco stick 100, or may be slightly larger than the outer diameter of the tobacco rod portion 110. It may also be slightly smaller than the outer diameter of the tobacco rod portion 110.

The heater 32 is provided within the accommodating cavity 313. The peripheral wall 312 and the rear wall 311 of the accommodating portion 310 are formed from a material having heat insulation performance and heat resistance performance so as to withstand the heat of the heater 32 and prevent the heat of the heater 32 from diffusing. Materials that can be cited for use in such an accommodating portion 310 include, for example, alumina-silica ceramics, and resins such as highly heat-resistant polyether ether ketone (PEEK), polyphenylene sulfide (PPS), and polytetrafluoroethylene (PTFE).

[Heater]

The heater 32 accepts a supply of electric power from the control unit 37, and generates heat to heat the tobacco stick 100 accommodated in the accommodating portion 310. That is, the heater 32 is one form of a heating portion that heats the tobacco stick 100.

The heater 32 is a generally tubular member provided along an outer peripheral surface 360 of the peripheral wall 312 of the accommodating portion 310. The heater 32 is an outer peripheral heating portion that heats the tobacco stick 100 from the outer peripheral side.

Furthermore, there is no particular restriction to the type of the heater 32, and examples that can be used include heaters in which a heat generating wire (for example, a wire material having a high electrical resistance such as nichrome, iron chromium, or iron nickel) is laid out on a steel material, or a ceramic heater or a sheathed heater. It should be noted that a sheathed heater is a heater in which a heat generating wire is covered with a filler and a metal pipe.

The heater (heating portion) 32 only needs to be capable of heating the tobacco rod portion 110 to generate an aerosol, and there is no particular restriction to the heating method. For example, although Fig. 4A illustrates a method for heating the tobacco rod from the inside, a method for heating the outer periphery of the tobacco rod wrapping paper or a heating method employing an inductive heater may be employed.

Fig. 4B is a drawing illustrating schematically the internal structure of the non-combustion-type flavor inhaler 30 provided with a microwave heating type heating portion (induction coil) 32A. A tobacco stick 100B includes, within the tobacco rod portion 110, a heat generating body (susceptor) 326 that generates heat by electromagnetic induction using a coil 325. The heat generating body 326 is a generally plate-shaped member formed longitudinally along the axial direction of the tobacco rod portion 110. There is no particular restriction to the shape of the heating element 326. The heating element 326 generates heat through electromagnetic induction, thereby heating the surrounding tobacco filler 111.

Fig. 4C is a drawing illustrating schematically the internal structure of the non-combustion-type flavor inhaler 30 provided with an internal heating type heater 32B. The heater 32B is a generally rod-shaped member extending along an axial direction of the accommodating cavity 313. The heater 32B is provided projecting forward in the axial direction from a central portion of the rear wall 311 of the accommodating portion 310. Reference sign 321 denotes a base end portion of the heater 32 and reference sign 322 denotes a tip end portion of the heater 32. The heater 32B has a conical shape that tapers gradually from the base end portion 321 towards the tip end portion 322. It should be noted that the shape of the heater 32B is not limited to this, and may be a rod shape having the same diameter from the base end portion 321 to the tip end portion 322, or a flat shape (blade shape).

When the tobacco stick 100 is inserted into the accommodating cavity 313, the heater 32B fits into the tobacco rod portion 110 from the tip end 102 of the tobacco stick 100. In this state, the heater 32B accepts a supply of electric power from the control unit 37 and heats the tobacco rod portion 110 to a prescribed temperature.

Here, within the accommodating cavity 313, a space that is heated to the prescribed temperature by means of the heat of the heater 32 (32A, 32B) is defined as a heated region A1, and a space adjacent to the insertion opening side of the heated region A1 in the axial direction (insertion/removal direction) is defined as a non-heated region A2. The non-heated region A2 is formed on the insertion opening side of the accommodating cavity 313, and the heated region A1 is formed on the interior side of the accommodating cavity 313. It should be noted that the heater 32 does not only heat parts that are in contact therewith, but also heats parts that are separated from the heater 32, by radiation or heat transfer. For example, the heater 32 heats to the prescribed temperature from the front end of the heater 32A to a position 317 on the insertion opening side in the axial direction. The heated region A1 is therefore a region from the position 317 to the rear wall 311 in the axial direction of the accommodating portion 310. That is, the position 317 is the boundary between the heated region A1 and the non-heated region A2, and the non-heated region A2 extends from the boundary 317 to the front end of the accommodating cavity 313 in the axial direction. It should be noted that the boundary 317 may be defined at the boundary between the region that reaches the prescribed temperature when actually heated by the heater 32 and the region that is below the prescribed temperature, or may be defined at an estimated boundary, by estimating the boundary between the region that reaches the prescribed temperature when the heater 32 generates heat under predetermined conditions, and the region that is below the prescribed temperature. It should be noted that in the present embodiment, a boundary position on the central axis CL between the region that is at the prescribed temperature and the region that is below the prescribed temperature is estimated, and a plane that passes through the boundary position and is perpendicular to the central axis CL is defined as the boundary 317, as indicated by the two-dash chain line in Fig. 4. When the tobacco stick 100 is inserted into the accommodating cavity 313, the tobacco rod portion 110 is located in the heated region A1, and at least a portion of the mouthpiece portion 120 is located in the non-heated region A2. It should be noted that when the tobacco stick 100 is in a predetermined state, for example in a state in which the tobacco stick 100 has been inserted into the accommodating cavity 313 until the tip end 102 of the tobacco stick 100 abuts the rear wall 311 of the accommodating portion 310, the part of the accommodating cavity 313 in which the tobacco rod portion 110 is located may be defined as the heated region A1 and the part thereof in which the mouthpiece portion 120 is located may be defined as the non-heated region A2.

[Sensor]

The capacitance sensor 33 is a sensor that detects the capacitance of the tip end of the tobacco stick 100 when the tobacco stick 100 has been accommodated in the accommodating portion 310. It should be noted that the tobacco rod portion 110 may be disposed in the tip end portion of the tobacco stick 100, or not at the tip end of the tobacco stick 100. For example, there may be a filter segment at the tip end of the tobacco stick 100. If there is a filter segment at the tip end, the capacitance of the tip end part of the tobacco stick 100 including the filter segment is detected. The capacitance sensor 33 has a first electrode (first electrode) 301 and a second electrode (second electrode) 302 and detects the capacitance between the first electrode 301 and the second electrode 302. The first electrode 301 and the second electrode 302 are disposed along the bottom surface 319 of the accommodating portion 310 with which the tip end of the tobacco stick 100 comes into contact when the tobacco stick 100 is inserted to the defined position relative to the accommodating portion 310. In other words, the first electrode 301 and the second electrode 302 are disposed on the same plane parallel to the bottom surface 319 of the accommodating portion 310, with their detecting surfaces facing the accommodating cavity 313 side. At this time, the capacitance generated between the electrodes 301 and 302 via the tobacco rod portion 110 varies depending on, for example, whether or not the tobacco rod portion 110 has been inserted, the insertion position of the tobacco rod portion 110, the moisture content of the tobacco filler in the tobacco rod portion 110, and the aerosol base material, for example. As such, the capacitance sensor 33 can detect information indicating the state of the tobacco rod portion 110 by detecting the capacitance. The first electrode 301 and the second electrode 302 are electrically connected to the control unit 37 via wires 307, and the capacitance detection result is acquired by the control unit 37.

Fig. 5 is a drawing illustrating an example in which the flat plate-shaped electrodes 301 and 302 are disposed along the rear wall 311 of the accommodating portion 310. As illustrated in Fig. 5, in the capacitance sensor 33, the flat plate-shaped first electrode 301 and the flat plate-shaped second electrode 302 are provided on the surface of the rear wall 311 of the accommodating portion 310 on the opposite side to the bottom surface 319, that is, on a surface 318 on the casing inner side where the control unit 37, etc., are accommodated. Further, the first electrode 301 and the second electrode 302 are disposed on the same flat surface 318 such that a minimum separation LA between the first electrode 301 and the second electrode 302 is 7 mm or less, preferably 4 mm or less. It should be noted that the first electrode 301 and the second electrode 302 may be disposed in close proximity to one another, separated by an insulating film or the like so as not to be electrically connected to one another.

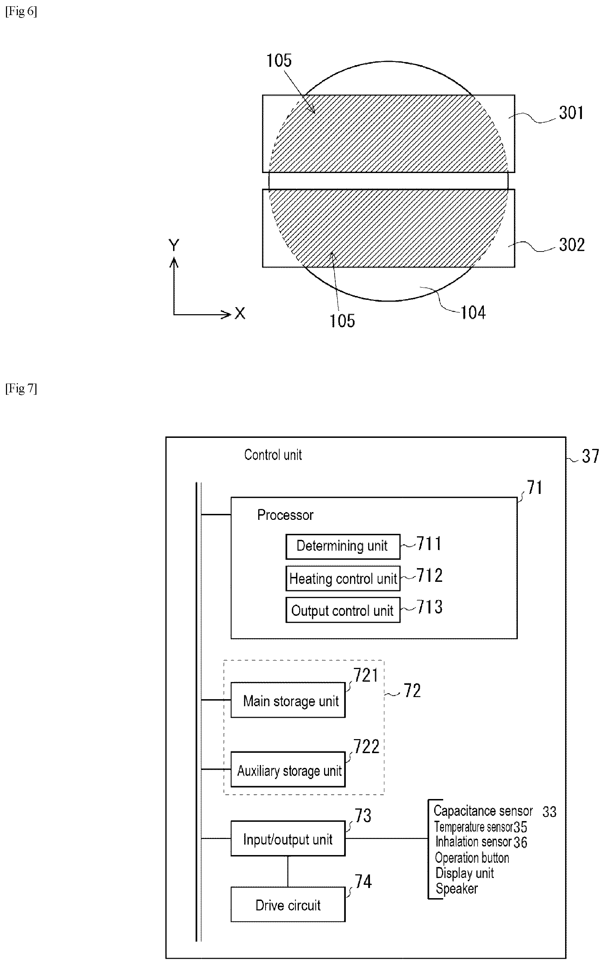

The first electrode 301 and the second electrode 302 of the capacitance sensor 33 are disposed opposing, in the Z direction, the tip end surface of the tobacco stick 100 that has been inserted to the defined position relative to the accommodating portion 310. Fig. 6 is a drawing illustrating the positional relationship between the first electrode 301 and the second electrode 301, and the tip end surface of the tobacco stick 100. In Fig. 6, reference sign 104 indicates the tip end surface of the tobacco stick 100. The first electrode 301 and the second electrode 302 are disposed so as to overlap the tip end surface 104 of the tobacco stick 100 in the Z direction, as illustrated in Fig. 6. The shaded part in Fig. 6 is a range 105 over which the first electrode 301 and the second electrode 302 overlap the tip end surface 104 of the tobacco stick 100. The ratio of the area of the overlapping range 105 to the total area of the tip end surface 104 in the tobacco stick 100 is at least equal to 40% and less than 100%, for example. By setting this ratio to be large, a stable detection result can be obtained.

Each electrode 301, 302 should have a shape that conforms to the tip end surface 104 of the tobacco stick 100, but there is no particular restriction to the outer shape thereof, for example. Although Fig. 6 illustrates an example in which the outer shape of each electrode 301 and 302 is rectangular, the outer shape may be another shape, such as an ellipse or a polygon other than a rectangle. For example, each electrode 301, 302 may be formed in a semicircular shape, such that, when both electrodes 301, 302 are disposed side-by-side on the same flat surface 318, the outer shapes of both electrodes 301, 302 form substantially the same circular shape as the tip end surface 104 of the tobacco stick 100.

Also, each electrode 301, 302 is provided on the surface 318 of the rear wall 311 of the accommodating portion 310 on the opposite side to the bottom surface 319, and is in close proximity to the tip end surface 104 of the tobacco stick 100 with the rear wall 311 interposed therebetween when accommodated within the casing. As a result, each electrode 301 and 302 is disposed in a position close to the tobacco stick 100 without competing with elements disposed around the accommodating portion 310, allowing the capacitance to be detected accurately while protecting each electrode 301 and 302 from impacts and dirt caused by the insertion and removal of the tobacco stick 100.

Furthermore, as illustrated in Fig. 1, the temperature sensor 35 is provided in the vicinity of the outer peripheral portion of the heated region A1 of the accommodating portion 310. The temperature sensor 35 is connected to the control unit 37, detects the temperature of the heated region A1, and inputs the detection result to the control unit 37. Furthermore, the accommodating portion 310 is provided with the inhalation sensor 36. The inhalation sensor 36 is a sensor for detecting a puffing state, such as whether a puff has been taken, and is, for example, a pressure sensor for detecting the pressure within the accommodating cavity 313. The inhalation sensor 36 is connected to the control unit 37 and inputs the detection result to the control unit 37. It should be noted that the temperature sensor 35 is not an essential component, and the temperature sensor 35 may be omitted if the detection result of the temperature sensor is not used for control, such as if the control unit 37 controls the temperature using the value of the current value supplied to the heater 32. Similarly, if the information relating to inhalation is not used for control, the inhalation sensor 36 may be omitted.

[Control unit]

Fig. 7 is a drawing illustrating the configuration of the control unit 37. The control unit 37 controls the operational state of the non-combustion-type flavor inhaler 30, such as controlling heating by means of the heater 32. The control unit 37 is a computer comprising a processor 71, such as a central processing unit (CPU), a digital signal processor (DSP), or a field-programmable gate array (FPGA), a memory 72, such as a random access memory (RAM) or a read only memory (ROM), and an input/output unit 73, for example. Furthermore, the control unit 37 of the present embodiment includes a drive circuit 74 for the heater 32.

The memory 72 may include a portion that functions as a main storage portion 721 and a portion that functions as an auxiliary storage portion 722. It should be noted that the memory 72 may be formed integrally with the processor 71 (as one chip). Examples of the memory 72 that can be cited include storage media such as volatile memory such as RAM, non-volatile memory such as ROM, erasable programmable ROM (EPROM), SSD, and removable media.

The memory 72 can store an operating system (OS), various programs (firmware), various data tables, various databases, setting data, user data, etc. for performing the operation of the non-combustion-type flavor inhaler 30.

The input/output unit 73 is a means for inputting operating information such as power source ON/OFF from the user (smoker) to the processor 71, or for outputting information to be presented to the user. The input/output unit 73 is an interface for operating the capacitance sensor 33, the temperature sensor 35, and the inhalation sensor 36 at prescribed timings, for example, and for obtaining detected values from each sensor 33, 35 and 36. Furthermore, the input/output unit 73 of the present embodiment may comprise operating buttons, an input means such as a touch panel, and an output means such as a display unit, a vibrator and a speaker. The input/output unit 73 may also comprise a communication unit for communicating with an external device via a communication line. For example, the communication unit can be connected to another computer via a communication cable to receive programs and data for controlling the non-combustion-type flavor inhaler 30 and store the same in the memory 72, and thereby update the firmware, heating profiles, etc. The display unit is a means for displaying information, and may be an indicator such as an LED, a liquid crystal display device, or an organic EL display device, for example.

The drive circuit 74 supplies electric power from the power source 38 to the heater 32 in accordance with a command from the processor 71, to operate the heater 32. The drive circuit 74 is a converter that regulates the amount of current passed to the heater 32, for example.

The control unit 37 reads the programs stored in the memory 72 by the processor 71 into a work area of the main storage portion for execution, and functions as prescribed functional units, such as a determining unit 711, a heating control unit 712, and an output control unit 713. It should be noted that these functional units are not limited to those realized on the basis of programs (software), and some or all of the functional units may be configured using a processor, integrated circuits, and hardware circuits such as logic circuits.

The determining unit 711 determines, on the basis of the detection results of each sensor 33, 35 and 36 and input information from the input means, information relating to operations performed by the user, the state of the tobacco stick 100, and the status of heating by the heater 32, for example. For example, the determining unit 711 determines, from the detected value from the capacitance sensor 33, at least one of: whether the tobacco stick 100 has been inserted to the defined position; the insertion position of the tobacco stick 100; whether the tobacco stick 100 has been heated; the moisture content of the tobacco stick 100; the amount of aerosol source in the tobacco stick 100; the amount of flavor source in the tobacco stick 100; and the type of flavor stick.

The heating control unit 712 controls the drive circuit 74 on the basis of the determination result of the determining unit 711 to thereby control the electric power supplied from the power source 38 to the heater 32 by way of the drive circuit 74. For example, the heating control 712 starts heating when it is determined that the tobacco stick 100 has been inserted into the accommodating cavity 313. In addition, the heating control 712 stops the power supply to the heater 32 and ends heating when the determining portion 711 determines that the moisture content or the amount of flavor source in the tobacco rod portion 110 has decreased and a state at which to end the heating has been reached.

The output control unit 713 outputs notifications, warnings, etc. to the user on the basis of the determination result from the determining unit 711. For example, the output control 713 outputs a warning if the insertion position of the tobacco stick 100 is not appropriate, and the output control 713 outputs the warning, etc., as an output to the user by means of a display to the display unit, a sound output by the speaker, or a vibration by the vibrator, for example.

[Detection of tobacco stick detection using capacitance sensor]

The detected value from the capacitance sensor 33 is low when the tobacco stick 100 is not inserted into the accommodating portion 310 and increases as the tobacco stick 100 is inserted into the accommodating portion 310 and approaches the capacitance sensor 33. For this reason, the value when the tobacco stick 100 is in the defined position is obtained experimentally, for example, and a threshold is defined on the basis of this value and is stored in the memory 72.

The determining unit 711 then determines that the tobacco stick 100 has been inserted to the defined position if the detected value from the capacitance sensor 33 exceeds the threshold. Furthermore, if the tobacco stick 100 has not been fully inserted to reach the bottom surface 319, the value of the capacitance differs depending on the distance between the capacitance sensor 33 and the tobacco stick 100.

Therefore, the determining portion 711 may obtain the distance between the tobacco stick 100 and the capacitance sensor 33, that is, the distance to the defined position, on the basis of the detected value from the capacitance sensor 303. Then, the control unit 37 may perform control based on the position of the tobacco stick 100, for example outputting a message such as "The stick is not fully inserted." "Please insert it another XX mm." as an audio output or a display output, on the basis of the calculated distance.A message such as an audio output or a display output, based on the position of the tobacco stick 100.

Furthermore, a plurality of thresholds may be set, and the determining unit 711 may turn on the power source when the detected value from the capacitance sensor 33 exceeds a first threshold H1, start heating when a second threshold H2 is exceeded, and inform the user that it has been determined that the tobacco stick 100 has reached the defined position and insertion is complete, i.e. that inhalation is possible, when a third threshold is exceeded.

Also, with regard to the detected value from the capacitance sensor 33, the capacitance is larger the greater the moisture content of the tobacco stick 100, and is smaller the lower the moisture content. For this reason, experiments are carried out to measure the capacitance while changing the moisture content of the tobacco stick 100 inserted to the defined position, and the values of the capacitance corresponding to the moisture content are stored in the memory 72 as a data table. The determining unit 711 may then obtain the moisture content corresponding to the detected value obtained by the capacitance sensor 33 from the data table. In addition, calibration data can be prepared by substituting the moisture content with the amount of flavor source or the amount of aerosol source, and the amount of flavor source of the amount of aerosol source can be obtained from the detected value of the capacitance. Furthermore, the moisture content or the value of the capacitance of a reference tobacco stick 100 before inhalation (unused state) and after inhalation is complete (used state) may be detected in advance and stored in the memory 72 as reference data, and when the tobacco stick 100 is inserted into the accommodating cavity 313, the control unit 37 may compare the moisture content and/or the value of the capacitance of the inserted tobacco stick 100 with the reference data to determine whether the inserted tobacco stick 100 has been used. In addition, the value of the capacitance of an unused tobacco stick 100 differs depending on the type of tobacco stick 100. For this reason, the capacitance is measured for each type of tobacco stick 100, and the values of the capacitance corresponding to the types of tobacco stick 100 are stored in the memory 72 as a data table. The control unit 37 may then obtain the type of tobacco stick 100 corresponding to the value of the capacitance of the inserted tobacco stick 100 from the data table.

[Control method]

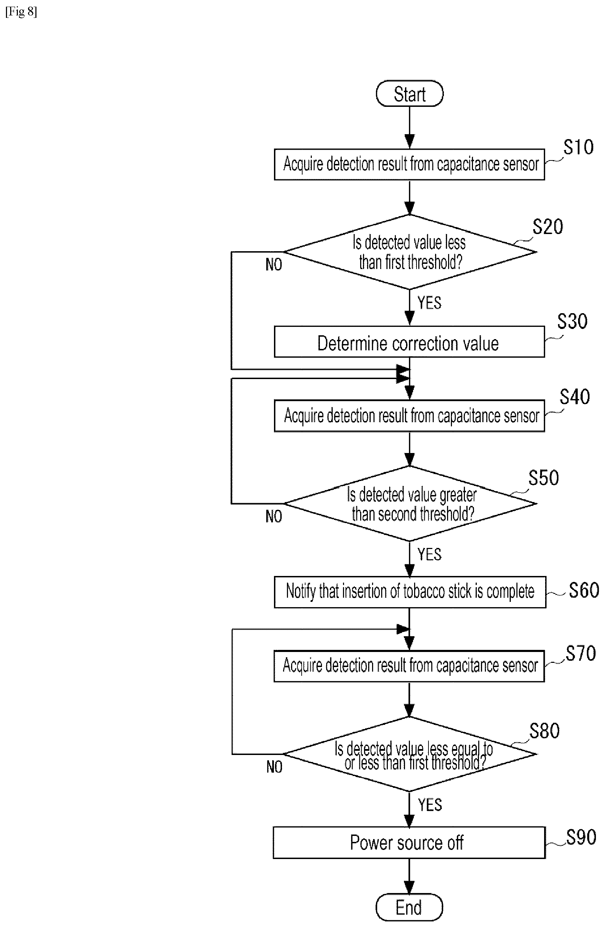

Fig. 8 is a drawing illustrating a control method executed by the control unit 37. The control unit 37 starts the processing of Fig. 8 when the power source of the non-combustion-type flavor inhaler 30 is turned on.

In step S10, the control unit 37 acquires the detected value from the capacitance sensor 33. In addition, the control unit 37 stores the acquired detected value in the memory 72.

In step S20, the control unit 37 determines whether the detected value detected in step S10 is equal to or less than the first threshold. The first threshold is the upper limit of the detected value obtained when no tobacco stick 100 is inserted into the accommodating portion 310. That is, the control unit 37 can determine that the tobacco stick 100 is in an uninserted state when the power source is turned on if the detected value detected in step S10 is equal to or less than the first threshold. If the determination in step S20 is affirmative, the control unit 37 proceeds to step S30 and determines a correction value for the capacitance detected by the capacitance sensor 33. The correction value is used to correct for impacts on the measured value of the capacitance due to individual differences between capacitance sensors 33 and external disturbance factors such as humidity when the power source is turned on. For example, the impact of external disturbance factors can be offset by taking the value detected in step S10 as zero and taking the difference between said value and the values detected in subsequent steps as the detection result (hereinafter also referred to as the first detection result), thereby making it possible to measure the capacitance accurately.

In step S40, the control unit 37 obtains the detected value from the capacitance sensor 33, corrects the detected value using the correction value determined in step S30, and acquires the result as the detection result. It should be noted that if the determination in step S20 is negative, i.e. a tobacco stick 100 was inserted when the power source was turned on, the detected value of step S10 is not used as the correction value, but the detected value from the capacitance sensor 33 may be corrected using a factory shipping value or a defined value.

In step S50, the controller 37 determines whether the first detection result acquired in step S40 is equal to or greater than the second threshold. The second threshold is the lower limit of the detected value obtained when the tobacco stick 100 has been inserted to the defined position. That is, the control unit 37 can determine that the tobacco stick 100 has reached the defined position if the detected value detected in step S40 is greater than or equal to the second threshold. It should be noted that if the determination in step S50 is negative, the control unit 37 returns to step S40 and repeats the detection of the capacitance. At this time, a message such as "Please insert a tobacco stick" may be output, indicating that the insertion of the tobacco stick 100 is not complete.

If the determination in step S50 is affirmative, the control unit 37 proceeds to step S60 and notifies the user that the insertion of the tobacco stick 100 is complete, for example by turning on an indicator.

In step S70, the control unit 37 obtains the detected value from the capacitance sensor 33, corrects the detected value using the correction value determined in step S30, and acquires the result as the detection result.

In step S80, the control unit 37 determines whether the detected value detected in step S70 is equal to or less than the first threshold. That is, the control 37 can determine that the tobacco stick 100 has been removed from the accommodating portion 310 if the detection result acquired in step S70 is equal to or less than the first threshold. The first threshold is set to a value that is sufficiently lower that the second threshold, and a hysteresis is provided between the determination of whether the tobacco stick 100 has been inserted and the determination of whether the tobacco stick 100 has been withdrawn, thereby suppressing erroneous detection.

If the determination in step S80 is affirmative, the control unit 37 proceeds to step S90, turns off the non-combustion-type flavor inhaler 30, and ends the processing of Fig. 9.

In the present embodiment, the detected value from the capacitance sensor 33 when the power source is turned on is used in step S30 to determine the correction value, but the configuration is not limited to this, and the value detected in step S70 immediately before the power source is turned off may be stored in step S80, and the correction value for the capacitance detected by the capacitance sensor 33 when the power source is next turned on may be determined on the basis of the value when the power source was turned off. It should be noted that the processing for correcting the value of the capacitance using this correction value and determining the state of the tobacco stick 100 is the same as the processing of Fig. 8 and Fig. 9 discussed hereinabove.

[Effects of embodiment]

In the non-combustion-type flavor inhaler 30 of the present embodiment, since the capacitance sensor 33 that detects the state of the tobacco stick 100 is disposed along the bottom surface 319 of the accommodating portion 310, thereby being disposed in close proximity to the tobacco stick 100 without competing with elements disposed around the accommodating portion 310, and thereby enabling the status of the tobacco stick 100 to be detected accurately, the performance of the non-combustion-type flavor inhaler 30 can be improved.

[Reference Signs List]

100: Tobacco stick
101: Mouthpiece end
102: Tip end
103: Ventilation hole
110: Tobacco rod portion
111: Filler
112: Wrapping paper
120: Mouthpiece portion
121: Cooling segment
122: Filter segment
130: Tipping paper
200: Non-combustion-type flavor inhalation system
30, 30A, 30B, 30C, 30D: Non-combustion-type flavor inhaler
301: First electrode
302: Second electrode
307, 308: Wire
31: Housing
310: Accommodating portion
311: Rear wall
312: Peripheral wall
313: Accommodating cavity
32: Heater
321: Base end portion
322: Tip end portion
325: Gap portion
325 Void portion
325: Coil
326: Heat generating body
33: Capacitance sensor
330: Flexible substrate
35: Temperature sensor
36: Inhalation sensor
37: Control unit
38: Power source (battery unit)
3A: Insertion opening
71: Processor
711: Determining unit
712: Heating control unit
713: Output control unit
72: Memory
73: Input/output unit
74: Drive circuit

**Claims**

1. A non-combustion-type flavor inhaler comprising

   an accommodating portion that accommodates a flavor stick having a flavor rod portion and a mouthpiece portion, so as to be capable of being inserted and removed,
   a control unit that controls electric power supplied to a heating portion for heating the flavor stick, to thereby heat the flavor stick by means of the heating portion, and
   a capacitance sensor that detects a capacitance that varies in accordance with the state of the flavor stick accommodated in the accommodating portion, wherein:

   the capacitance sensor comprises a first electrode and a second electrode; and
   the first electrode and the second electrode are disposed along a bottom surface of the accommodating portion with which a tip end of the flavor stick comes into contact when the flavor stick is inserted to a defined position relative to the accommodating portion.

2. The non-combustion-type flavor inhaler as claimed in claim 1, wherein, when the insertion of the flavor stick has been detected by the capacitance sensor, the control unit performs at least one of turning on the power source, starting heating by means of the heating portion, and notifying the user that the insertion of the flavor stick is complete.

3. The non-combustion-type flavor inhaler as claimed in claim 1 or 2, wherein the control unit determines that insertion of the flavor stick is complete when the value of the capacitance detected by the capacitance sensor reaches a prescribed threshold.

4. The non-combustion-type flavor inhaler as claimed in claim 3, wherein the control unit detects the capacitance by means of the capacitance sensor when the power source is turned on and no flavor stick has been inserted into the accommodating portion, and corrects the value of the capacitance detected by the capacitance sensor on the basis of the detection result.

5. The non-combustion-type flavor inhaler as claimed in claim 3, wherein the control unit detects the capacitance by means of the capacitance sensor at the time the power source is turned off, if no flavor stick is inserted into the accommodating portion, and corrects the value of the capacitance detected by the capacitance sensor when the power source is next turned on, on the basis of the detection result.

6. The non-combustion-type flavor inhaler as claimed in any one of claims 1 to 3, wherein the capacitance sensor is disposed such that the minimum gap between the first electrode and the second electrode, on the same plane along a bottom surface of the accommodating portion, is 7 mm or less.

7. The non-combustion-type flavor inhaler as claimed in any one of claims 1 to 4, wherein the capacitance sensor is disposed so as to overlap, in the direction in which the flavor stick is inserted and removed, a range of 40% or more and less than 100% of a tip end surface of the flavor stick that has been inserted

**EP 4 616 740 A1**

to the defined position.

[Fig 1]

[Fig 2]

[Fig 3]

[Fig 4A]

[Fig 4B]

[Fig 4C]

[Fig 5]

[Fig 6]

[Fig 7]

[Fig 8]

```
                        ┌─────────────┐
                        │    Start    │
                        └──────┬──────┘
                               │
                               ▼
        ┌──────────────────────────────────────────────┐  S10
        │ Acquire detection result from capacitance sensor │
        └──────────────────────┬───────────────────────┘
                               │
                               ▼
                      ◇────────────────────◇  S20
              NO      │ Is detected value less │
          ┌───────────│  than first threshold? │
          │           ◇────────────┬───────────◇
          │                        │ YES
          │                        ▼
          │          ┌──────────────────────────┐  S30
          │          │  Determine correction value │
          │          └─────────────┬────────────┘
          │                        │
          └───────────────────────►│
                                   ▼
        ┌──────────────────────────────────────────────┐  S40
        │ Acquire detection result from capacitance sensor │
        └──────────────────────┬───────────────────────┘
                               │
                               ▼
                      ◇────────────────────◇  S50
              NO      │ Is detected value greater │
          ┌───────────│  than second threshold?   │
          │           ◇────────────┬───────────◇
          │                        │ YES
          │                        ▼
          │      ┌──────────────────────────────────┐  S60
          │      │ Notify that insertion of tobacco stick is complete │
          │      └──────────────┬───────────────────┘
          │                     │
          └────────────────────►│
                                ▼
        ┌──────────────────────────────────────────────┐  S70
        │ Acquire detection result from capacitance sensor │
        └──────────────────────┬───────────────────────┘
                               │
                               ▼
                      ◇────────────────────◇  S80
              NO      │ Is detected value less equal to │
              (loop)  │ or less than first threshold?   │
                      ◇────────────┬───────────◇
                                   │ YES
                                   ▼
                      ┌──────────────────────┐  S90
                      │    Power source off   │
                      └───────────┬──────────┘
                                  │
                                  ▼
                           ┌─────────────┐
                           │     End     │
                           └─────────────┘
```

## INTERNATIONAL SEARCH REPORT

| International application No. |
| --- |
| **PCT/JP2022/042129** |

| A. CLASSIFICATION OF SUBJECT MATTER |
| --- |
| *A24F 40/51*(2020.01)i; *G01R 27/26*(2006.01)n; *G01V 3/08*(2006.01)n <br> FI: A24F40/51; G01V3/08 D; G01R27/26 C |

According to International Patent Classification (IPC) or to both national classification and IPC

| B. FIELDS SEARCHED |
| --- |
| Minimum documentation searched (classification system followed by classification symbols) <br> A24F40/51; G01R27/26; G01V3/08 |
| Documentation searched other than minimum documentation to the extent that such documents are included in the fields searched <br> Published examined utility model applications of Japan 1922-1996 <br> Published unexamined utility model applications of Japan 1971-2022 <br> Registered utility model specifications of Japan 1996-2022 <br> Published registered utility model applications of Japan 1994-2022 |
| Electronic data base consulted during the international search (name of data base and, where practicable, search terms used) |

| C. DOCUMENTS CONSIDERED TO BE RELEVANT | | |
| --- | --- | --- |
| Category* | Citation of document, with indication, where appropriate, of the relevant passages | Relevant to claim No. |
| Y | JP 2017-510270 A (BRITISH AMERICAN TOBACCO (INVESTMENTS) LIMITED) 13 April 2017 (2017-04-13) <br> paragraphs [0027]-[0048], fig. 1-2 | 1-7 |
| Y | JP 2022-524729 A (PHILIP MORRIS PRODUCTS S.A) 10 May 2022 (2022-05-10) <br> paragraphs [0175]-[0184] | 1-7 |
| A | WO 2022/071267 A1 (FUTURE TECH CO LTD) 07 April 2022 (2022-04-07) <br> entire text, all drawings | 1-7 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **06 December 2022** | **20 December 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2022/042129**

| Patent document cited in search report | | | Publication date (day/month/year) | Patent family member(s) | | | Publication date (day/month/year) |
|---|---|---|---|---|---|---|---|
| JP | 2017-510270 | A | 13 April 2017 | US | 2018/0049469 | A1 | |
| | | | | paragraphs [0047]-[0068], fig. 1-2 | | | |
| | | | | WO | 2015/140312 | A1 | |
| | | | | EP | 3119224 | A1 | |
| | | | | KR | 10-2016-0124853 | A | |
| | | | | CN | 106455707 | A | |
| JP | 2022-524729 | A | 10 May 2022 | US | 2022/0160051 | A1 | |
| | | | | paragraphs [0185]-[0194] | | | |
| | | | | WO | 2020/193240 | A1 | |
| | | | | EP | 3941249 | A1 | |
| | | | | CN | 113498319 | A | |
| | | | | KR | 10-2021-0141527 | A | |
| WO | 2022/071267 | A1 | 07 April 2022 | JP | 2022-56938 | A | |

Form PCT/ISA/210 (patent family annex) (January 2015)

## REFERENCES CITED IN THE DESCRIPTION

**Patent documents cited in the description**

- JP 2017510270 A

- WO 2019185748 A1

**Non-patent literature cited in the description**

- Dictionary of Tobacco. Tobacco Academic Studies Center, 31 March 2009